# EUROPEAN PATENT APPLICATION

(11) **EP 4 645 379 A1**
(43) Date of publication of application: **05.11.2025**
(21) Application number: 25164378.9
(22) Date of filing: 18.03.2025
(51) Int. Cl.: H01L 21/768, H01L 21/3115, H01L 23/532, H01L 23/522

(54) **LOW-K INTERCONNECT DIELECTRIC BY SELECTIVE IMPLANTATION**

(30) Priority: 29.04.2024 US 202418648560
(71) Applicant: NXP USA, Inc., Austin, TX 78735 (US)
(72) Inventor: SHROFF, Mehul D., 5656 AG Eindhoven (NL); DEMIRCAN, Ertugul, 5656 AG Eindhoven (NL); REBER, Douglas Michael, 5656 AG Eindhoven (NL)
(74) Representative: Hardingham, Christopher Mark

(57) **Abstract**

A multi-level interconnect structure is formed on a semiconductor wafer to include conductive interconnect structures formed over an interconnect region and capacitor-terminal structures formed over a capacitor region by selectively implanting one or more inter-layer dielectric (ILD) layers over the interconnect region with a capacitance-reducing implant species while protecting each ILD layer over the capacitor region from the capacitance-reducing implant species, thereby forming a relatively lower-capacitance interconnect structure over the interconnect region and a relatively higher-capacitance capacitor over the capacitor region.

## Description

### BACKGROUND OF THE INVENTION

### Field of the Invention

The present disclosure is directed in general to the field of semiconductor devices. In one aspect, the present disclosure relates to interconnect structures formed above a substrate.

### Description of the Related Art

Modern integrated circuits (ICs) typically have conductor structures formed in a plurality of inter-layer dielectric (ILD) layers to provide conductive interconnect levels, which provide electrical connections to and from circuitry that is formed on the IC substrate. These conductors can be used to transfer information in the form of signals sent to and from ICs formed on an underlying substrate. In addition, conductor structures may be formed in the ILD layers to provide other circuit elements, such as capacitor plates that are electrically connected to the circuitry that is formed on the IC substrate. After forming the circuitry on the substrate during front-end-of-line (FEOL) processing, existing copper metallization techniques for semiconductor wafer-fabrication form inter-level conductor structures in a series of ILD layers by patterning and etching each ILD layer to form etch openings, plating, and/or filling each etch opening with one or more conductive layers, and then applying a chemical-mechanical planarization (CMP) or polish step to remove the conductive layer(s) from outside the etch openings. With existing fabrication techniques that form the interconnect conductor structures and capacitor-terminal structures in the same ILD layers, there are increasingly performance trade-offs between the interconnect and capacitor structures formed in different regions. For example, the use of low-k (dielectric constant) ILD materials in advanced nodes provides improved interconnect performance by reducing the parasitic capacitance between interconnect conductor structures, but this can negatively impact the performance of capacitors. In particular, if the capacitor dielectric is formed from low-k ILD materials, then capacitors of larger sizes are needed to obtain required levels of capacitance (costing area and leakage) and/or require more aggressive spacing (which may not always be possible and can exacerbate breakdown risks). These design challenges and trade-offs are exacerbated with high-performance IC fabrication processes where signals traversing the interconnect conductors operate at very high frequencies over conductors having smaller spacing, which can cause increased parasitic capacitance that adversely impacts the speed and power of ICs. Thus, existing processes to fabricate interconnects have not provided the cost, speed, and electrical performance required for leading-edge IC devices that integrate both interconnect and capacitor circuit elements in the ILD layers formed over the substrate. Further limitations and disadvantages of conventional processes and technologies will become apparent to one of skill in the art after reviewing the remainder of the present application with reference to the drawings and detailed description which follow.

### BRIEF DESCRIPTION OF THE DRAWINGS

The present invention may be understood, and its numerous objects, features and advantages obtained, when the following detailed description of a preferred embodiment is considered in conjunction with the following drawings.
Figures 1-10 illustrate cross-sectional views at different stages of manufacture of a semiconductor structure having interconnect and capacitor structures formed in selectively implanted ILD layers in accordance with selected embodiments of the present disclosure.
Figure 11 illustrates a simplified fabrication-process flow for integrating relatively lower-k interconnect structures with capacitor structures in accordance with selected embodiments of the present disclosure.

### DETAILED DESCRIPTION

A process for fabricating ICs and resulting IC devices are described for integrating relatively lower-k dielectric layers with relatively higher-k dielectric layers used to form interconnect and capacitor structures in a multi-level interconnect structure. In selected embodiments, the lower-k dielectric layers are formed at each layer of a multi-level interconnect using a selective implantation process whereby an initial dielectric layer is patterned with an implantation mask before implanting predetermined species (such as nitrogen, fluorine, argon, and/or xenon) at specified implant dosages and energies into exposed portions of the initial dielectric layer in the interconnect region to form the relatively lower-k dielectric layer in the interconnect region, while leaving the protected initial dielectric layer as a relatively higher-k dielectric layer in the capacitor region. In selected embodiments, conductive metal/via structures and capacitor structures are formed (e.g., with copper metallization or aluminum metallization patterning) after species implantation at each level using any suitable damascene process which etches patterned openings in the implanted relatively lower-k dielectric layer and protected relatively higher-k dielectric layer, followed by filling the etched openings with one or more conductive layers before depositing another dielectric layer. In such embodiments, the concentration and implantation energy of the implanted species is controlled or limited to prevent or reduce having any effect on the patterned etching of the dielectric layer, though any suitable etch optimization may be applied to simultaneously handle the etching of implanted and un-implanted regions. In other embodiments, the conductive metal and via connectors are formed prior to selective species implantation. In such embodiments, the concentration and implantation energy is controlled to reduce or eliminate any impact on the conductive metal and via connectors, though one or more implantation-optimization processes may be used. For example, if nitrogen is used as the implant into copper via or metal layers, any resulting copper nitride can be decomposed by applying a controlled thermal process (e.g., ~250 °C anneal).

In this disclosure, an improved IC structure and method of manufacture are described for forming a multi-level interconnect structure which integrates relatively lower-k dielectric layers in the interconnect region with relatively higher-k dielectric layers in the capacitor region as part of, or after, the back-end-of-line (BEOL) process to address various problems in the art where various limitations and disadvantages of conventional solutions and technologies will become apparent to one of skill in the art after reviewing the remainder of the present application with reference to the drawings and detailed description provided herein. Various illustrative embodiments of the present invention will now be described in detail with reference to the accompanying figures. While various details are set forth in the following description, it will be appreciated that the present invention may be practiced without these specific details, and that numerous implementation-specific decisions may be made to the invention described herein to achieve the device designer's specific goals, such as compliance with process-technology requirements or design-related constraints, which will vary from one implementation to another. While such a development effort might be complex and time-consuming, it would nevertheless be a routine undertaking for those of ordinary skill in the art having the benefit of this disclosure. For example, selected aspects are depicted with reference to simplified cross-sectional drawings of a semiconductor device without including every device feature or geometry in order to avoid limiting or obscuring the present invention. Such descriptions and representations are used by those skilled in the art to describe and convey the substance of their work to others skilled in the art. It is also noted that, throughout this detailed description, certain elements in the figures are illustrated for simplicity and clarity and have not necessarily been drawn to scale. In addition, the dimensions of some of the elements in the figures may be exaggerated relative to other elements to help improve the understanding of the embodiments of the present disclosure. Further, reference numerals have been repeated among the drawings to represent corresponding or analogous elements. In addition, the depicted device layers that are shown as being deposited and/or etched are represented with simplified line drawings, though it will be appreciated that, in reality, the actual contours or dimensions of device layers will be non-linear, such as when the described etch processes are applied at different rates to different materials, or when the described deposition or growth processes generate layers based on the underlaying materials.

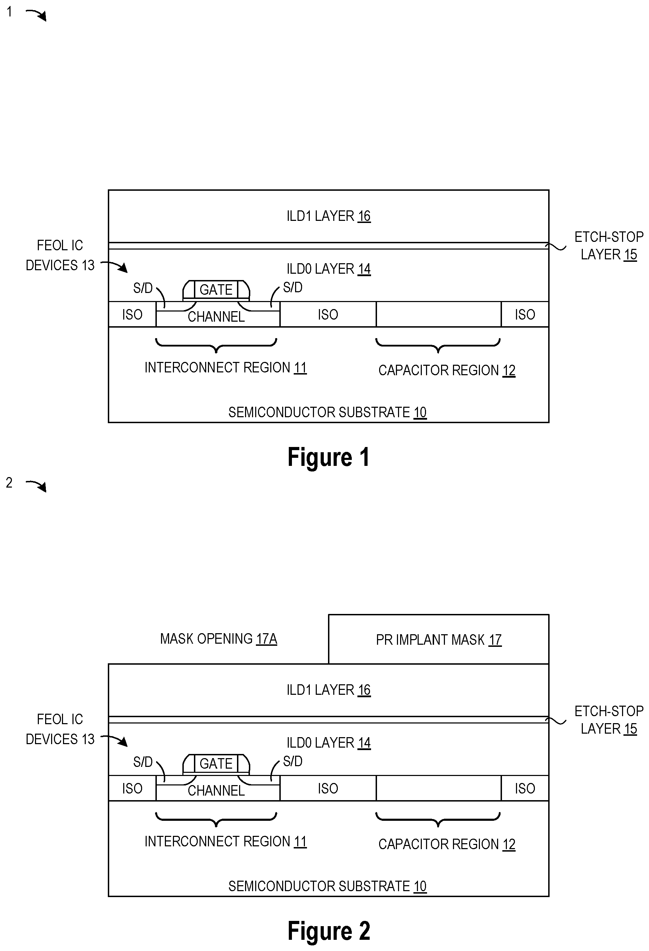

Various illustrative embodiments of the present invention will now be described in detail with reference to Figures 1-11. In addition, although specific example materials, thicknesses, and processes are described herein, those skilled in the art will recognize that other materials, thicknesses, and processes with similar properties or characteristics can be substituted without loss of function. It is noted that, throughout this detailed description, certain layers of materials will be deposited and removed to form the semiconductor structure. Where the specific procedures for processing such layers or thicknesses of such layers are not detailed below, conventional techniques known to one skilled in the art for depositing, removing, forming, or otherwise processing such layers at appropriate thicknesses shall be intended. Such details are well known and not considered necessary to teach one skilled in the art how to make or use the present invention.

For an improved understanding of selected embodiments of the present disclosure, reference is now made to Figures 1-10 which illustrate cross-sectional views at different stages of manufacture of a semiconductor structure having interconnect structures formed using selective implantation of dielectric layers to integrate relatively lower-k dielectric layers with relatively higher-k dielectric layers in a multi-level interconnect structure. In particular, Figure 1 illustrates in cross-sectional form a portion of a semiconductor structure 1 having one or more inter-layer dielectric (ILD) layers ILD0 14, ILD1 16, and an optional first etch-stop layer (ESL) 15 formed over a semiconductor substrate 10 in which one or more IC devices or elements 13 are fabricated with FEOL wafer-processing steps. As will be appreciated, the FEOL IC devices or elements 13 may include one or more transistors, resistors, capacitors, diodes, or other semiconductor components that are formed on or in a semiconductor substrate with any suitable semiconductor material or combinations of materials, such as gallium arsenide, gallium nitride, silicon germanium, semiconductor-on-insulator (SOI), strained semiconductor-on-insulator (SSOI), silicon, monocrystalline silicon, and the like. As depicted, the transistors may be formed over an interconnect region 11, and may include gates formed over source/drain (S/D) regions of a channel. Adjacent to the interconnect region 11 is a capacitor region 12 over which capacitor elements may be formed. As depicted, the interconnect region 11 and capacitor region 12 are separated from one another by isolation regions (ISO) and denote the portions of the interconnect structure in which the interconnect and capacitor elements are formed. To protect the IC elements, an initial insulating layer ILD0 14 may be formed with any suitable insulating material. For example, a planarized boro-phosphorous tetra-ethyl ortho-silicate (BPTEOS) layer may form all or part of an initial inter-layer dielectric (ILD0) layer 14 that provides a gettering function to help protect IC elements and to control the field leakage between semiconductor transistors.

After forming the initial ILD0 layer, an ESL 15 (such as SiN, SiC, SiCN, SiON, SiCON, or the like) may optionally be deposited to a predetermined thickness on the entire surface of the semiconductor structure 1 to serve as a base for forming the initial metal (M1) interconnect level. On the ESL 15, a bottom ILD layer 16 is formed with a suitable deposited dielectric material (e.g., SiO₂, SiOC, SiOF, methyl silsesquioxane (MSQ), or other suitable dielectric materials) to a predetermined thickness on the entire surface of the semiconductor structure. In selected embodiments, the bottom ILD layer 16 may be formed with any dielectric material that is suitable for capacitor-structure formation, including but not limited to tetra-ethyl ortho-silicate (TEOS), fluorinated tetra-ethyl ortho-silicate (FTEOS), or other dielectric material having a dielectric constant, k, that is at least as high as the value of k of silicon dioxide, SiO₂, which is 3.9. Dielectric materials having k>3.9 are referred to as "high"-k dielectrics, while dielectric materials having k<3.9 are defined as "low"-k dielectrics. In some embodiments, the dielectric layer may be deposited to a thickness greater than the final desired thickness and then be etched back or planarized to improve thickness uniformity across the semiconductor wafer.

Figure 2 illustrates processing of the semiconductor structure 2 subsequent to Figure 1 after forming a first patterned implant-mask layer 17 on the semiconductor structure in accordance with selected embodiments of the present disclosure. While any suitable mask-patterning process may be used, the first implant photoresist (PR) mask 17 may be formed on the first ILD 1 layer 16 by sequentially depositing, patterning, etching, and/or developing a PR layer formed with any material that is suitable for photolithography. As depicted, the first patterned photoresist implant mask layer 17 includes a defined opening 17A which exposes the underlying first ILD 1 layer 16 at an intended interconnect region 11 for forming a multi-level interconnect structure.

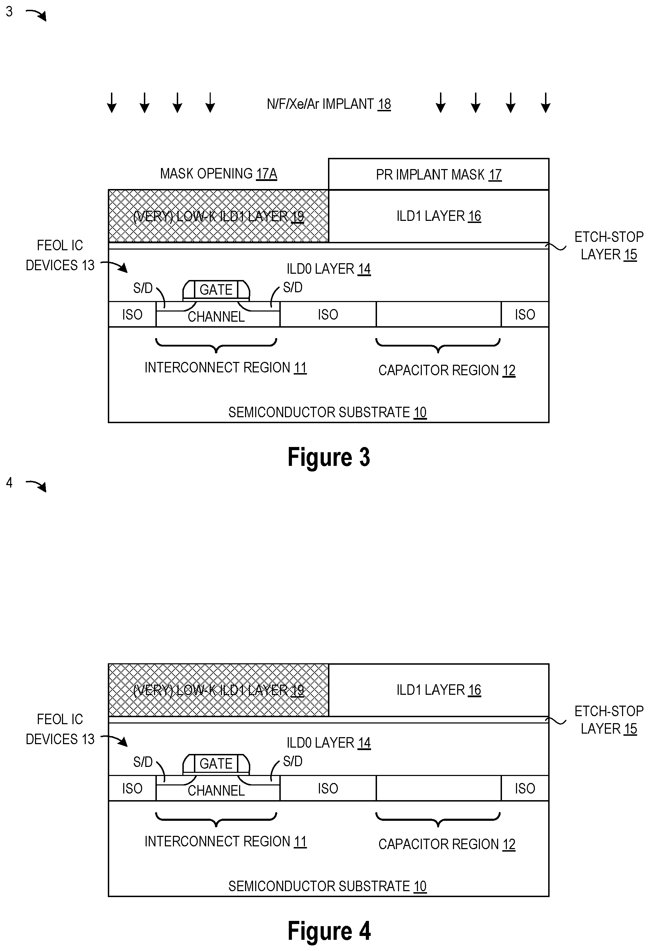

Figure 3 illustrates processing of the semiconductor structure 3 subsequent to Figure 2 after one or more implantation processes 18 are applied to selectively implant the exposed portion of the ILD layer 16, thereby forming low-k or very low-k implanted ILD 1 layer 19 in accordance with selected embodiments of the present disclosure. In selected implantation embodiments, the implanted ILD1 layer 19 may be formed by implanting selected species at a predetermined implant energy and dopant concentration so as to disrupt the structural properties of the ILD layer 16, thereby reducing the dielectric constant of the implanted ILD1 layer 19. Example implant species include, but are not limited to nitrogen, fluorine, argon, or xenon. The implantation effects may include increasing the porosity, reducing the polarizability, or reducing the film density. For example, by implanting nitrogen into an ILD layer 16 formed with MSQ to a predetermined implant energy and dopant concentration (e.g., N = 1E15 atoms/cm² at an energy of 20 keV), the resulting implanted ILD1 layer 19 initially has a low-k dielectric constant (e.g., k=2.1), which can be further lowered to approximately 2.03-2.04 by applying a thermal treatment after the implantation. In addition, by co-implanting fluorine with nitrogen into the ILD layer 16 formed with MSQ to a predetermined implant energy and dopant concentration (e.g., F = 1E14 keV/cm² at an energy of 40 keV), the resulting implanted ILD1 layer 19 initially has a low-k dielectric constant (e.g., k=1.68) which can be lowered to approximately 1.6 by applying a thermal treatment. In addition, by increasing the implantation energy and concentration of co-implanted fluorine with nitrogen into the ILD layer 16 (e.g., F = 1E14 keV/cm² at an energy of 40 keV), the resulting implanted ILD 1 layer 19 has a low-k dielectric constant (e.g., k=1.51), though this value may increase or decrease slightly by applying a thermal treatment after the implantation.

In other embodiments, an ILD layer 16 formed with MSQ that is implanted with an implant species dose of approximately 1E14-1E15 atoms/cm² will result in a concentration of approximately 1E18-1E19 atoms/cm³ under typical implant conditions, reducing the MSQ molecular concentration from 1.5E21 atoms/cm³ (non-porous) to 1.05E21 atoms/cm³ (30% porous). The resulting implant dose will be < ~1% by volume which is unlikely to appreciably impact etch rates or sidewall profiles of the implanted MSQ ILD layer 19 during subsequent damascene processing. Alternatively, any etch chemistry or rate used during damascene processing can be optimized as needed to account for changed properties of the MSQ ILD 19 caused by implantation.

In other embodiments, an ILD layer 16 formed with silicon dioxide that is implanted with 300 keV xenon at an implant species dose of approximately 1E16 to 5E16 cm⁻² will result in the formation and the thermal evolution of bubbles or cavities in the silicon dioxide, which remain present even after a 1100 °C annealing, while Xe strongly desorbs out at that temperature, resulting in very low-k dielectric constant (k) values smaller than 1.6.

In other embodiments, an ILD layer 16 formed with silicon dioxide that is implanted with fluorine using a triple-implant process at increasing implant energies and implant species dosages will result in the formation of an implanted ILD1 layer 19 that has smaller dielectric constant (k) values (e.g., k=2.9).

Figure 4 illustrates processing of the semiconductor structure 4 subsequent to Figure 3 after the first patterned implant mask layer 17 is removed or stripped from the semiconductor structure to expose the un-implanted ILD1 layer 16. While any suitable resist-strip process may be used, an example process may remove the first patterned implant mask layer 17 by using a plasma-based ash process and/or wet-etch chemistry that selectively removes the first patterned implant mask layer 17 without etching the underlying ILD 1 layers 16, 19. At this point in the fabrication process, the selectively implanted ILD1 layer 19 has a relatively lower dielectric constant value k1, and the un-implanted ILD 1 layer 16 layer has a relatively higher dielectric constant value k2>k1.

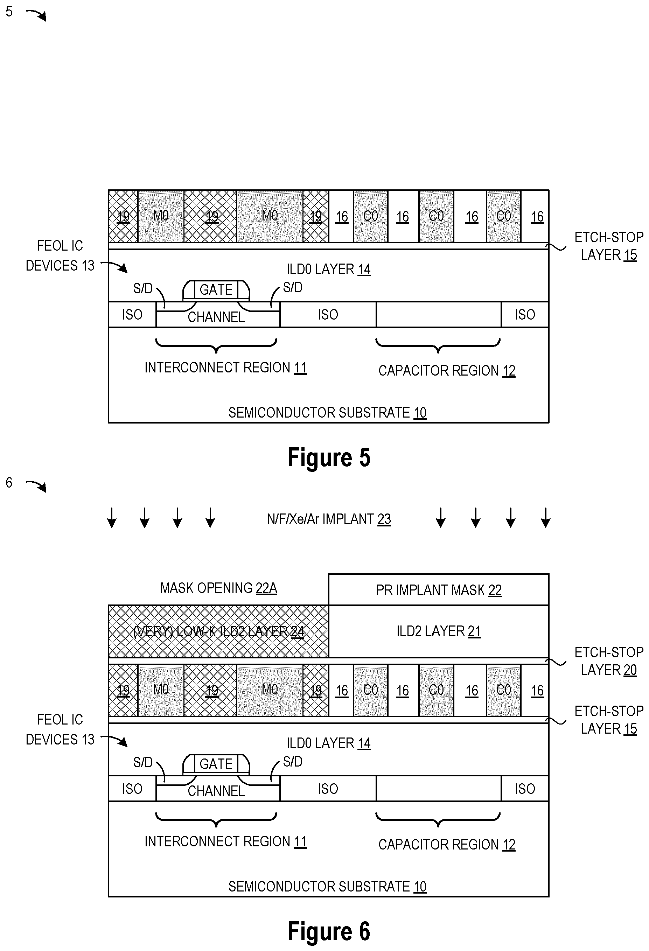

Figure 5 illustrates processing of the semiconductor structure 5 subsequent to Figure 4 after selectively forming conductive metal structures M0 and capacitor structures C0 in the underlying ILD 1 layers 16, 19 by sequentially depositing, planarizing, patterning and/or etching any suitable conductive material (e.g., aluminum, copper, tantalum, tungsten, tantalum nitride, tungsten nitride, titanium, titanium nitride, or the like and combinations of the above) to fill etched openings in the underlying ILD1 layers 16, 19. For example, each constituent interconnect conductor layer M0 may be formed over the interconnect region 11 in etched openings formed in the implanted relatively lower-k dielectric layer 19 using chemical vapor deposition (CVD), plasma-enhanced chemical vapor deposition (PECVD), physical vapor deposition (PVD), atomic-layer deposition (ALD), focused ion beam (FIB) deposition, Electron Beam-Induced Deposition (EBID), micro-chemical vapor deposition, laser-focused deposition, laser-focused atomic deposition, or any other suitable global or localized deposition techniques or any combination(s) of the above to a predetermined final thickness. In similar fashion, each constituent capacitor-terminal layer C0 may be formed over the capacitor region 12 in etched openings formed in the un-implanted relatively higher-k dielectric layer 16 using any suitable global or localized deposition techniques. While the specific arrangement, construction, and connection of the different interconnect and capacitor-terminal layers M0, C0 layers are not important, each may be constructed in the underlying ILD1 layers 16, 19 using a damascene process in which conductive layers M0, C0 are deposited in openings formed in the underlying ILD1 layers 16, 19 and then polished or etched back. Though not shown, it will be appreciated that initial via structures V0 may be selectively formed in the initial insulating layer ILD0 14 using any suitable process for depositing, planarizing, patterning and/or etching any suitable conductive material. For example, the conductive layers V0, M0, C0 may be simultaneously formed with a dual-damascene patterning process, or may be formed sequentially with a single-damascene patterning process.

Figure 6 illustrates processing of the semiconductor structure 6 subsequent to Figure 5 after sequentially depositing an (optional) second ESL 20 and second ILD2 layer 21 over the semiconductor structure 6, and then selectively applying one or more implantation processes 23 using a second patterned implant mask layer 22 to form a low-k or very low-k implanted ILD2 layer 24 over the interconnect region 11 in accordance with selected embodiments of the present disclosure. As described hereinabove, the second ILD2 layer 21 may be formed on the second ESL 20 using any suitable dielectric material that is deposited to a predetermined thickness on the entire surface of the semiconductor structure 6. In selected embodiments, the second ILD2 layer 21 may be formed with any dielectric material that is suitable for capacitor-structure formation. On the second ILD2 layer 21, the second patterned implant mask layer 22 may be formed, such as by depositing, patterning, etching, and/or developing a photoresist (PR) layer with a defined opening 22A which exposes the underlying second ILD2 layer 21 at an intended interconnect region 11 for forming a multi-level interconnect structure. With the second patterned implant mask layer 22 formed, the implantation process(es) 23 is/are applied to selectively implant the exposed portion of the second ILD2 layer 21 with a suitable implant species (e.g., nitrogen, fluorine, argon, or xenon) at a controlled implant energy and dosage to form low-k or very low-k implanted ILD2 layer 24.

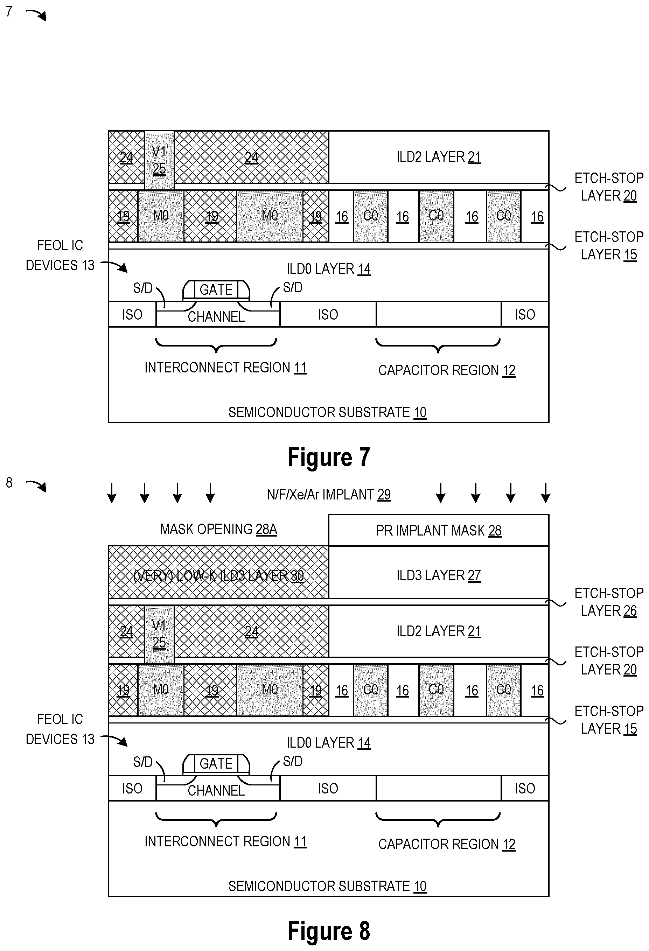

Figure 7 illustrates processing of the semiconductor structure 7 subsequent to Figure 6 after selectively forming conductive via structures V1 25 in the interconnect region 11. After stripping or removing the second patterned implant mask layer 22, the conductive via structures V1 25 may be formed in the implanted ILD2 layer 24 with a single-damascene patterning process by sequentially depositing, planarizing, patterning, and/or etching any suitable conductive material to fill etched via openings in the underlying ILD2 layer 24. As will be appreciated, the conductive via structures V1 25 may be formed simultaneously with the conductive layers M1, C1 described hereinbelow by using a dual-damascene patterning process. For example, each constituent via conductor layer V1 25 may be formed over the interconnect region 11 in etched openings formed in the implanted relatively lower-k dielectric layer 24 and second ESL 20 using a damascene process in which the via conductor layer V1 25 is deposited in openings formed in the underlying ILD2 layer 24 and ESL 20, and then polished or etched back.

Figure 8 illustrates processing of the semiconductor structure 8 subsequent to Figure 7 after sequentially depositing an (optional) third ESL 26 and third ILD3 layer 27 over the semiconductor structure 8, and then selectively applying one or more implantation processes 29 using a third patterned implant mask layer 28 to form a low-k or very low-k implanted ILD3 layer 30 over the interconnect region 11 in accordance with selected embodiments of the present disclosure. As described hereinabove, the third ILD3 layer 27 may be formed on the third ESL 26 using any suitable dielectric material that is deposited to a predetermined thickness on the entire surface of the semiconductor structure 8. In selected embodiments, the third ILD3 layer 27 may be formed with any dielectric material that is suitable for capacitor structure formation. On the third ILD3 layer 27, the third patterned implant mask layer 28 may be formed, such as by depositing, patterning, etching, and/or developing a photoresist (PR) layer with a defined opening 28A which exposes the underlying third ILD3 layer 27 at an intended interconnect region 11 for forming a multi-level interconnect structure. With the third patterned implant mask layer 23 formed, the implantation process(es) 29 are applied to selectively implant the exposed portion of the third ILD3 layer 27 with a suitable implant species (e.g., nitrogen, fluorine, argon, or xenon) at a controlled implant energy and dosage to form low-k or very low-k implanted ILD2 layer 24.

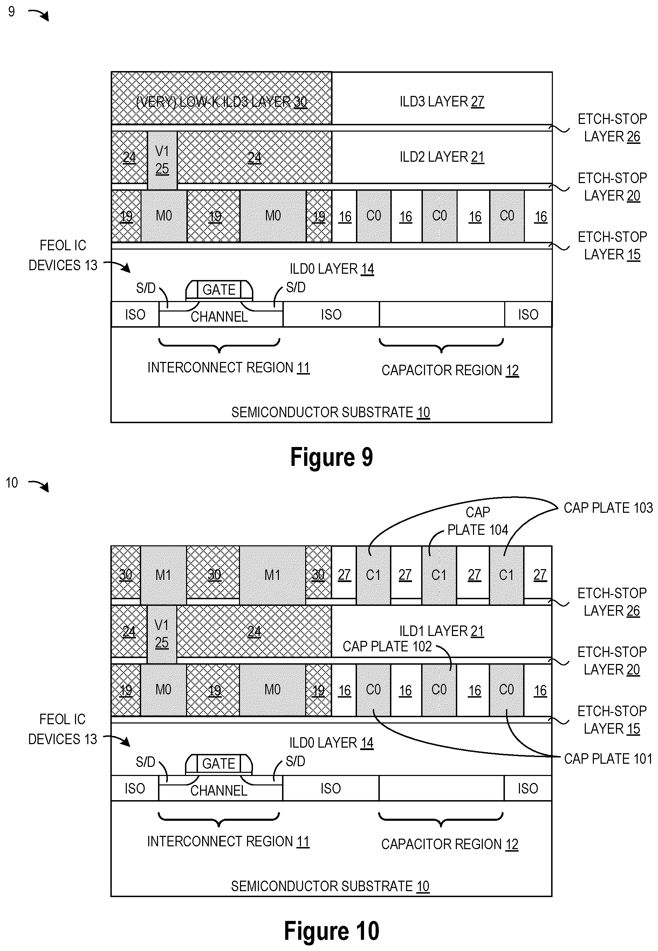

Figure 9 illustrates processing of the semiconductor structure 9 subsequent to Figure 8 after stripping or removing the third patterned implant mask layer 28. While any suitable resist strip process may be used, an example process may remove the third patterned implant mask layer 28 by using a plasma-based ash process and/or wet-etch chemistry that selectively removes the third patterned implant mask layer 28 without etching the underlying ILD3 layers 27, 30. At this point in the fabrication process, the selectively implanted ILD3 layer 30 has a relatively lower dielectric constant value k1, and the un-implanted ILD3 layer 27 layer has a relatively higher dielectric constant value k2>k1.

Figure 10 illustrates processing of the semiconductor structure 10 subsequent to Figure 9 after selectively forming conductive metal structures M1 and capacitor structures C1 in the third ILD3 layers 27, 30 by sequentially depositing, planarizing, patterning, and/or etching any suitable conductive material to fill etched openings in the underlying ILD3 layers 27, 30. For example, each constituent interconnect conductor layer M1 may be formed over the interconnect region 11 in etched openings formed in the implanted relatively lower-k dielectric layer 30 to a predetermined final thickness using any other suitable deposition or localized deposition techniques. In similar fashion, each constituent capacitor-terminal layers C1 may be formed over the capacitor region 12 in etched openings formed in the un-implanted relatively higher-k dielectric layer 27 using any suitable deposition or localized deposition techniques. While the specific arrangement, construction, and connection of the different interconnect and capacitor-terminal layers M1, C1 layers is not important, each may be constructed in the underlying third ILD3 layers 27, 30 using a damascene process in which conductive layers M1, C1 are deposited in openings formed in the underlying third ILD3 layers 27, 30 and then polished or etched back.

In the depicted example of Figure 10, the capacitor structures C0 formed in the bottom ILD 1 layer 16 may form a first single-layer capacitor which is constructed with interleaved capacitor plate layers, including the outermost pair of capacitor structures C0 forming a first capacitor plate 101, which is interleaved with the central capacitor structure C0 forming a second capacitor plate 102, which are separated by the capacitor dielectric ILD layer 16. In similar fashion, the capacitor structures C1 formed in the uppermost ILD2 layer 27 may form a second single-layer capacitor, which is constructed with interleaved capacitor plate layers, including the outermost pair of capacitor structures C1 forming a first capacitor plate 103, which is interleaved with the central capacitor structure C1 forming a second capacitor plate 104, which are separated by the capacitor dielectric ILD layer 27. While this example shows the first and second single-layer capacitors being formed with capacitor fingers that are aligned in parallel, it will be appreciated that the first and second single-layer capacitors may be formed with capacitor fingers that are arranged orthogonally to one another. In alternative embodiments, capacitor-terminal layers C0, C1 may form separate terminals of the capacitor structure. In other embodiments, two successive dielectric layers may be implanted together with a higher energy implant than is used for implanting a single dielectric layer. In such embodiments, the interconnect metal and via features may then be formed together using dual-damascene patterning and metallization. In other embodiments, each dielectric layer may be individually implanted over the interconnect region and the interconnect metal and via layers may be formed together using dual-damascene patterning and metallization.

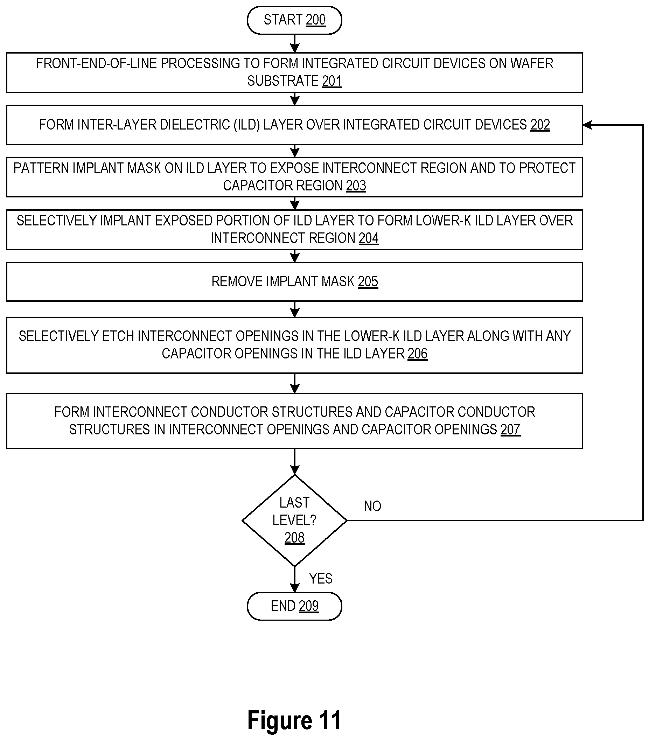

Turning now to Figure 11, there is illustrated a simplified process flow 200-209 for fabricating a semiconductor wafer with integrated lower-k dielectric layers and higher-k dielectric layers used to form interconnect and capacitor structures in a multi-level interconnect structure in accordance with selected embodiments of the present disclosure. Though selected embodiments of the semiconductor wafer-fabrication methodology are described with reference to an example BEOL fabrication process, it will be appreciated by persons skilled in the art that the sequence of illustrated steps may be used in any suitable stage of the device-fabrication process, and may be modified, reduced or augmented in keeping with the disclosure of the present disclosure. Thus, it will be appreciated that the methodology of the present disclosure may be thought of as performing the identified sequence of steps in the order depicted in Figure 11, though the steps may also be performed in parallel, in a different order, or as independent operations that are combined.

After the disclosed fabrication methodology starts (step 200), one or more FEOL processing steps 201 are performed to fabricate a wafer substrate with IC elements (e.g., transistors, capacitors, resistors, diodes, etc.) that are to be connected to a multi-level interconnect structure and to one or more capacitor structures formed in a plurality of ILD layers. Generally speaking, FEOL processing is the first portion of IC fabrication where the individual components (transistors, capacitors, resistors, etc.) are formed in the semiconductor, and generally covers everything up to (but not including) the deposition of interconnect layers.

At step 202, an initial inter-layer dielectric (ILD) layer is formed over the IC elements on the wafer substrate. In an example embodiment, the initial ILD layer may be formed by depositing a dielectric material using CVD, PECVD, PVD, ALD, FIB deposition, EBID, micro-chemical vapor deposition, laser-focused deposition, laser-focused atomic deposition, or any other suitable global or localized deposition techniques or any combination(s) of the above to a predetermined final thickness. In addition, the dielectric material may include, but is not limited to, SiO₂, SiOC, SiOF, MSQ, TEOS, FTEOS, or other dielectric material having a dielectric constant, k, that is at least as high as the value of k of silicon dioxide, SiO₂.

At step 203, an implant mask is patterned on the ILD layer to expose the ILD layer in a designated interconnect region and to protect the ILD layer in a designated capacitor region. In selected embodiments, the implant mask may be formed by depositing or coating the wafer substrate with a photoresist layer that is subsequently developed and exposed to transfer a pattern from a mask to the wafer so that the implant mask protects the ILD layer located in the capacitor region(s) and has openings defined to expose the ILD layer located in the interconnect region(s) of the wafer substrate.

At step 204, portions of the ILD layer exposed by the implant mask over the interconnect region are selectively implanted to form lower-k ILD layers. In an example embodiment, the implant power and dosage of the implant process and species are controlled to selectively implant a selected implant species (e.g., nitrogen, fluorine, argon, or xenon) in the exposed portions of the ILD layer over a designated interconnect region, but not in protected portions of the ILD layer over a designated capacitor region. As a result of altering the structure and density of the implanted ILD layer, the implant(s) will decrease the capacitance of the ILD layer in the interconnect regions as compared to the capacitance of the ILD layer in the capacitor regions, thereby enabling capacitors to be formed with higher capacitance and reducing capacitance between conductive metal/via structures in the multi-level interconnect structure.

At step 205, the implant mask is removed from the wafer substrate. Depending on what materials are used to form the implant mask, one or more appropriate etch processes may be applied to selectively remove the implant mask. For example, a patterned photoresist implant mask may be stripped with an ash/piranha process, though other resist-removal processes may be used.

At step 206, interconnect openings may be selectively etched in the lower-k ILD layer along with any capacitor openings in the ILD layer. For example, interconnect and capacitor openings can be formed simultaneously or sequentially by using any suitable masked etch process, such as by forming a patterned photoresist layer as an etch mask and then applying one or more anisotropic etch processes to etch openings into exposed portions of the underlying ILD layers.

At step 207, interconnect conductor structures and capacitor-terminal structures are formed in the interconnect and capacitor openings. In an example embodiment, one or more conductive layers may be formed to fill the interconnect and capacitor openings by sequentially depositing one or more conductive metal layers (e.g., a barrier liner layer, seed layer, and electroplated-copper layer), planarizing the deposited conductive metal layer(s), and then patterning and etching the conductive metal layer(s) to define the desired interconnect conductor structures and capacitor-terminal structures in the underlying ILK layer.

At step 208, the fabrication methodology determines if the last layer of the capacitor structure has been completed. If not (negative outcome to detection step 208), then the methodology returns to step 202 to form the next ILD layer over the wafer substrate, and steps 202-208 are repeated to selectively implant the next ILD layer and to form interconnect conductor structures in the implanted portion of the next ILD layer over the interconnect region, and to form capacitor-terminal structures in the un-implanted portion of the next ILD layer over the capacitor region. As a result, the fabrication processing steps 202-208 are iteratively repeated until the wafer substrate has a completed multi-level interconnect formed with (very) low-k ILD layers over the interconnect region and a completed capacitor formed with relatively higher-k ILD layers over the capacitor region, including first and second plate conductor layers separated by a dielectric capacitor layer formed with un-implanted ILD layers. In selected embodiments, the completed capacitor may be a metal-oxide-metal (MOM) capacitor, fringe capacitor, or other high-capacitance capacitor that provides crucial functionality for analog/precision circuits. When the last level of the multi-level structure has been completed (affirmative outcome to detection step 208), then the method ends (step 209). As will be appreciated, there may be additional metallization layers (not shown) that are formed over the last capacitor layer where the differentiated low-k and higher-k ILD layers are not needed, such as when a top metal layer is formed before the fabrication process ends at step 209.

As described hereinabove, the metallization is done after the selectively implanting the ILD layer in the interconnect region. In such cases, the concentration of the implanted species in the ILD layer is low enough that it is not likely to fundamentally affect the subsequent etch processing of the implanted ILD layer, though some etch optimization may be needed to simultaneously etch the implanted and un-implanted regions. As will be appreciated, the fabrication processing steps 201-209 may be adjusted or reordered or consolidated in other sequences. For example, the fabrication steps 206-207 may be consolidated into a combined metallization fabrication step using any suitable technique for fabricating interconnect and capacitor-terminal structures. In addition or in the alternative, the selective implantation steps 203-204 may occur after forming the interconnect and capacitor-terminal structures in the ILD layer. For example, nitrogen may be selectively implanted into an ILD layer in which copper interconnect and capacitor structures have previously been formed. In this example, the resulting Cu₃N formed in the copper interconnect and capacitor structures may be removed by applying a thermal treatment (e.g., 250 °C anneal), which decomposes the Cu₃N formed in the copper interconnect and capacitor structures.

While the process flow steps 200-209 are directed to performing damascene patterning after selective dielectric implantation, it will be appreciated by persons skilled in the art that the fabrication processes can be adjusted, modified, and/or altered for use with other interconnect fabrication processes which employ aluminum patterning, implantation after metallization, simultaneous implantation of two successive dielectric layers, dual-damascene patterning and metallization processes, separate implantation of the dielectric layers over the interconnect region and the interconnect metal, and the like.

As described hereinabove, the present disclosure provides a mechanism for integrating relatively low-k dielectric ILD interconnect layers with relatively high-k dielectric capacitor ILD layers by selectively implanting the interconnect region of each ILD layer with appropriate implant species, energy, and dosage so that low-capacitance multi-level interconnects and higher capacitance capacitor elements are integrated in the same fabrication sequence. The disclosed process may be used with porous, organic, low-k dielectrics used in advanced technologies so that interconnect capacitors are blocked from receiving the ILD implant to maintain a higher dielectric constant in these regions, whereas interconnect regions receive the ILD implant to reduce the dielectric constant in the interconnect regions.

By now, it should be appreciated that there has been provided a semiconductor wafer with IC devices and interconnect structures formed on the semiconductor wafer and associated method of fabrication. In the disclosed methodology, a semiconductor wafer is provided that contains a plurality of IC devices. The disclosed methodology also includes forming an interconnect structure over the plurality of IC devices on the semiconductor wafer which includes a plurality of conductive interconnect structures formed over a first region and a plurality of capacitor-terminal structures formed over a second region by selectively implanting a dielectric constant-changing implant species into one or more inter-layer dielectric (ILD) layers located over the first region, but not into the one or more ILD layers located over the second region, so that the one or more ILD layers located over the first region have a different dielectric constant than the one or more layers located over the second region. In selected embodiments, the interconnect structure is formed by depositing, for each level of the interconnect structure, a dielectric layer having a first dielectric constant value over the semiconductor wafer which covers the first region and the second region; forming, for each level of the interconnect structure, an implant mask on the dielectric layer with a defined opening which exposes the dielectric layer over the first region but not over the second region; and implanting the dielectric constant-changing implant species into the dielectric layer through the defined opening of the implant mask to form an implanted dielectric layer having a second dielectric constant value that is smaller than the first dielectric constant value. In such embodiments, the dielectric layer may be formed by depositing a layer of silicon dioxide (SiO2), silicon oxycarbide (SiOC), fluorine-doped silicon oxide (SiOF), methyl silsesquioxane (MSQ), tetraethyl orthosilicate (TEOS), or fluorinated tetraethyl orthosilicate (FTEOS) to a predetermined thickness. In addition, the implant mask may be formed by coating, developing and exposing a photoresist (PR) layer to form a patterned PR implant mask on the dielectric layer with the defined opening which exposes the dielectric layer over the first region but not over the second region. In addition, the implanted dielectric constant-changing implant species may be nitrogen, fluorine, argon, or xenon that is implanted into the dielectric layer through the defined opening of the implant mask. In selected embodiments, for each level of the interconnect structure, the dielectric constant-changing implant species are implanted into an ILD layer prior to forming the plurality of conductive interconnect structures and the plurality of capacitor-terminal structures in the ILD layer. In other selected embodiments, for each level of the interconnect structure, the dielectric constant-changing implant species are implanted into an ILD layer after forming the plurality of conductive interconnect structures and the plurality of capacitor-terminal structures in the ILD layer. In selected embodiments, the interconnect structure is formed by selectively implanting the one or more ILD layers over the plurality first regions with a capacitance-reducing implant species while protecting the one or more of ILD layers over the second region from the capacitance-reducing implant species, thereby forming the one or more ILD layers over the first region to have a lower dielectric constant value than the one or more ILD layers formed over the second region.

In another form, there has been provided an integrated circuit device with one or more integrated circuit components and a multi-level interconnect structure formed on the semiconductor substrate and associated method of fabrication. In the disclosed integrated circuit device, the multi-level interconnect structure includes a plurality of first metal structures formed in a first plurality of inter-layer dielectric (ILD) layers and electrically coupled to at least some of the one or more IC components. In selected embodiments, the plurality of first metal structures includes a plurality of conductive metal interconnects and vias of damascene interconnect structures in the first plurality of ILD layers. In addition, the multi-level interconnect structure includes a plurality of second metal structures formed in a second plurality of ILD layers and electrically coupled to at least some of the one or more IC components. In selected embodiments, the plurality of second metal structures includes a plurality of capacitor-terminal damascene structures in the second plurality of ILD layers. As formed, the first plurality of ILD layers has a first concentration of dielectric constant-changing implant species and a first dielectric constant value, and the second plurality of ILD layers has a second concentration of dielectric constant-changing implant species and a second dielectric constant value which is different from the second dielectric constant value. In selected embodiments, each ILD layer in the first plurality of ILD layers may include a layer of silicon dioxide (SiO₂), silicon oxycarbide (SiOC), fluorine-doped silicon oxide (SiOF), methyl silsesquioxane (MSQ), tetraethyl orthosilicate (TEOS), or fluorinated tetraethyl orthosilicate (FTEOS) that has been implanted with the dielectric constant-changing implant species. In selected embodiments, the dielectric constant-changing implant species may be nitrogen, fluorine, argon, or xenon. In selected embodiments, each ILD layer in the second plurality of ILD layers may include a layer of silicon dioxide (SiO₂), silicon oxycarbide (SiOC), fluorine-doped silicon oxide (SiOF), methyl silsesquioxane (MSQ), tetraethyl orthosilicate (TEOS), or fluorinated tetraethyl orthosilicate (FTEOS) that has not been implanted with the dielectric constant-changing implant species. In selected embodiments, the plurality of first metal structures form a damascene interconnect structure in the first plurality of ILD layers having a first relatively lower dielectric constant value, and the plurality of second metal structures form a damascene capacitor structure in the second plurality of ILD layers having a second relatively higher dielectric constant value.

In yet another form, there has been provided an integrated circuit device and associated method of fabricating one or more integrated circuit components and a multi-level interconnect structure on a semiconductor substrate. In the disclosed method, a plurality of integrated circuit (IC) devices is formed on the semiconductor substrate. In addition, the disclosed method includes forming a planarized dielectric layer over the semiconductor substrate to cover the plurality of IC devices. In selected embodiments, the planarized dielectric layer may be formed by depositing a layer of silicon dioxide (SiO2), silicon oxycarbide (SiOC), fluorine-doped silicon oxide (SiOF), methyl silsesquioxane (MSQ), tetraethyl orthosilicate (TEOS), or fluorinated tetraethyl orthosilicate (FTEOS) to a predetermined thickness. In other selected embodiments, the planarized dielectric layer may be formed by depositing, for each level of a multi-level interconnect structure, a dielectric layer having a first dielectric constant value which covers the first region and the second region. The disclosed method also includes selectively implanting a capacitance-reducing implant species, such as nitrogen, fluorine, argon, or xenon, into a first region of the planarized dielectric layer while protecting a second region of the planarized dielectric layer from implantation by the capacitance-reducing implant species, thereby forming the first region of the dielectric layer with a first dielectric constant value and the second region of the dielectric layer with a second dielectric constant value that is larger than the first dielectric constant value. In selected embodiments, the capacitance-reducing implant species may be selectively implanted by forming, for each level of a multi-level interconnect structure, an implant mask on the dielectric layer with a defined opening which exposes the dielectric layer over the first region but not over the second region, and implanting the capacitance-reducing implant species into the dielectric layer through the defined opening of the implant mask to form an implanted dielectric layer having a second dielectric constant value that is smaller than the first dielectric constant value. In addition, the disclosed method includes forming one or more conductive structures in the first and second regions of the planarized dielectric layer. In selected embodiments, the one or more conductive structures may be formed with a plurality of conductive interconnect structures formed in the first region of the planarized dielectric layer and a plurality of capacitor-terminal structures formed in the second region of the planarized dielectric layer.

Although the described exemplary embodiments disclosed herein are directed to various semiconductor and IC device structures and methods for making the same, the present invention is not necessarily limited to the example embodiments which illustrate inventive aspects of the present invention that are applicable to a wide variety of semiconductor processes and/or devices. Thus, the particular embodiments disclosed above are illustrative only and should not be taken as limitations upon the present invention, as the invention may be modified and practiced in different but equivalent manners apparent to those skilled in the art having the benefit of the teachings herein. Accordingly, the foregoing description is not intended to limit the invention to the particular form set forth, but on the contrary, is intended to cover such alternatives, modifications and equivalents as may be included within the scope of the invention as defined by the appended claims so that those skilled in the art should understand that they can make various changes, substitutions and alterations without departing from the scope of the invention in its broadest form.

Benefits, other advantages, and solutions to problems have been described above with regard to specific embodiments. However, the benefits, advantages, solutions to problems, and any element(s) that may cause any benefit, advantage, or solution to occur or become more pronounced are not to be construed as a critical, required, or essential feature or element of any or all the claims. As used herein, the terms "comprises," "comprising," or any other variation thereof, are intended to cover a non-exclusive inclusion, such that a process, method, article, or apparatus that comprises a list of elements does not include only those elements but may include other elements not expressly listed or inherent to such process, method, article, or apparatus.

## Claims

1. A method for fabricating integrated-circuit, IC, devices, comprising:
providing a semiconductor wafer containing a plurality of IC devices; and
forming an interconnect structure over the plurality of IC devices on the semiconductor wafer which comprises a plurality of conductive interconnect structures formed over an first region and a plurality of capacitor-terminal structures formed over a second region by selectively implanting a dielectric constant-changing implant species into one or more inter-layer dielectric, ILD, layers located over the first region, but not into the one or more ILD layers located over the second region, so that the one or more ILD layers located over the first region have a different dielectric constant than the one or more layers located over the second region.

2. The method of claim 1, where forming the interconnect structure comprises:
depositing, for each level of the interconnect structure, a dielectric layer having a first dielectric constant value over the semiconductor wafer which covers the first region and the second region;
forming, for each level of the interconnect structure, an implant mask on the dielectric layer with a defined opening which exposes the dielectric layer over the first region but not over the second region; and
implanting the dielectric constant-changing implant species into the dielectric layer through the defined opening of the implant mask to form an implanted dielectric layer having a second dielectric constant value that is smaller than the first dielectric constant value.

3. The method of claim 2, where depositing the dielectric layer comprises depositing a layer of silicon dioxide, SiO₂, silicon oxycarbide, SiOC, fluorine-doped silicon oxide, SiOF, methyl silsesquioxane, MSQ, tetraethyl orthosilicate, TEOS, or fluorinated tetra-ethyl ortho-silicate, FTEOS, to a predetermined thickness.

4. The method of claim 2 or 3, where forming the implant mask comprises coating, developing and exposing a photoresist (PR) layer to form a patterned PR implant mask on the dielectric layer with the defined opening that exposes the dielectric layer over the first region but not over the second region.

5. The method of any of claims 2 to 4, where implanting the dielectric constant-changing implant species comprises implanting at least one of nitrogen, fluorine, argon, or xenon into the dielectric layer through the defined opening of the implant mask.

6. The method of any preceding claim, wherein, for each level of the interconnect structure, the dielectric constant-changing implant species are implanted into an ILD layer prior to forming the plurality of conductive interconnect structures and the plurality of capacitor-terminal structures in the ILD layer.

7. The method of any preceding claim, wherein, for each level of the interconnect structure, the dielectric constant-changing implant species are implanted into an ILD layer after forming the plurality of conductive interconnect structures and the plurality of capacitor-terminal structures in the ILD layer.

8. The method of any preceding claim, where forming the interconnect structure comprises selectively implanting one or more ILD layers over the first region with a dielectric constant-changing implant species while protecting the one or more ILD layers over the second region from the dielectric constant-changing implant species, thereby forming the one or more ILD layers over the first region to have a lower dielectric constant value than the one or more ILD layers formed over the second region.

9. The method of any preceding claim, the plurality of conductive interconnect structures and the plurality of capacitor-terminal structures are formed in each of the one or more ILD layers before or after selectively implanting each of the one or more ILD layers.

10. An integrated-circuit, IC, device comprising:
a semiconductor substrate comprising one or more IC components; and
a multi-level interconnect structure formed on the semiconductor substrate, the multi-level interconnect structure comprising:
a plurality of first metal structures formed in a first plurality of inter-layer dielectric, ILD, layers and electrically coupled to at least some of the one or more IC components, and
a plurality of second metal structures formed in a second plurality of ILD layers and electrically coupled to at least some of the one or more IC components;
where the first plurality of ILD layers comprises a first concentration of dielectric constant-changing implant species and has a first dielectric constant value, and where the second plurality of ILD layers comprises a second concentration of dielectric constant-changing implant species and has a second dielectric constant value which is different from the first dielectric constant value.

11. The integrated-circuit device of claim 10, where the plurality of first metal structures comprises a plurality of conductive metal interconnects and vias of damascene interconnect structures in the first plurality of ILD layers, and where the plurality of second metal structures comprises a plurality of capacitor-terminal damascene structures in the second plurality of ILD layers.

12. The integrated-circuit device of claim 10 or 11, where each ILD layer in the second plurality of ILD layers comprises a layer of silicon dioxide SiO₂, silicon oxycarbide, SiOC, fluorine-doped silicon oxide SiOF, methyl silsesquioxane MSQ, tetraethyl orthosilicate, TEOS, or fluorinated tetraethyl orthosilicate, FTEOS that has not been implanted with the dielectric constant-changing implant species.

13. The integrated-circuit device of any of claims 10 to 12, where each ILD layer in the first plurality of ILD layers comprises a layer of silicon dioxide, SiO₂, silicon oxycarbide, SiOC, fluorine-doped silicon oxide, SiOF, methyl silsesquioxane, MSQ, tetraethyl orthosilicate, TEOS, or fluorinated tetraethyl orthosilicate, FTEOS, that has been implanted with the dielectric constant-changing implant species.

14. The integrated-circuit device of any of claims 10 to 13, where the dielectric constant-changing implant species comprises at least one of nitrogen, fluorine, argon, or xenon.

15. The integrated-circuit device of any of claims 10 to 14, where the plurality of first metal structures form a damascene interconnect structure in the first plurality of ILD layers having a first relatively lower dielectric constant value, and where the plurality of second metal structures form a damascene capacitor structure in the second plurality of ILD layers having a second relatively higher dielectric constant value.
